# FASCICULE DE BREVET EUROPEEN

(11) **EP 3 430 443 B1**
(45) Date de publication et mention de la délivrance du brevet: **22.04.2020**
(21) Numéro de dépôt: 17715236.0
(22) Date de dépôt: 15.03.2017
(51) Int. Cl.: G01V 3/10

(54) **DISPOSITIF DÉTECTEUR INDUCTIF DE FACTEUR 1**
INDUKTIVE FAKTOR-1-SENSORVORRICHTUNG
FACTOR 1 INDUCTIVE SENSOR DEVICE

(30) Priorité: 16.03.2016 FR 1652242
(43) Date de publication de la demande: 23.01.2019
(73) Titulaire: Senstronic (Société Par Actions Simplifiée), 67700 Saverne (FR)
(72) Inventeur: LOTZ, Thomas, 67310 Wasselonne (FR)
(74) Mandataire: Cabinet Nuss
(86) Numéro de dépôt international: PCT/FR2017/050587
(87) Numéro de publication internationale: WO 2017/158287

(56) Documents cités:
- EP-A1- 1 530 064
- WO-A1-2015/143500
- US-A1- 2003 184 301
- US-A1- 2014 376 586

## Description

La présente invention concerne le domaine des dispositifs de détection inductif, permettant de détecter la présence à un endroit ou une position donnée, ou la proximité, d'un objet métallique, en particulier les détecteurs mis en œuvre dans l'industrie et reposant sur l'analyse du signal fourni par au moins un circuit résonnant LC.

De tels détecteurs sont commercialisés par la demanderesse depuis de nombreuses années et sont, par exemple, décrits dans les documents FR 2 827 677, EP 1 580 889, EP 1 580 536, EP 1 965 177 et EP 2 546 614.

L'invention a plus spécifiquement pour objet un dispositif détecteur de proximité ou de présence, de type inductif et de "facteur 1", c'est-à-dire conçu et fonctionnant de manière à présenter préférentiellement une très faible variation de distance de détection pour les différents principaux matériaux métalliques (acier, aluminium, laiton, cuivre, zinc, ...).

Dans le cas d'un détecteur inductif conventionnel, la distance de détection nominale Sn est toujours donnée pour une cible en acier (norme EN60947-5-2). Pour les autres métaux, tels que l'aluminium ou le cuivre, pour déterminer la distance de détection, il est nécessaire d'appliquer un facteur de correction sur cette portée nominale Sn. Par exemple, la distance de détection pour l'aluminium peut être de 0,40 x Sn (facteur 0,40) ou de 0,70 x Sn (facteur 0,70) pour l'acier inoxydable. Pour l'acier, le facteur vaut 1, c'est-à-dire une distance de détection de 1 x Sn = Sn.

Il est rappelé qu'en termes de détection, les matériaux métalliques peuvent être classés en deux catégories :
- les matériaux ferromagnétiques (acier, fer) qui, lorsqu'ils sont à proximité d'une bobine de détection, ont tendance à faire augmenter la résistance série Rs de la bobine (l'inductance série Ls variant peu) ;
- les matériaux non ferromagnétiques (aluminium, cuivre, laiton...) qui, lorsqu'ils sont à proximité d'une bobine de détection, ont tendance à faire diminuer l'inductance série Ls de la bobine (Rs variant peu).

Dans l'état de la technique, un détecteur peut être qualifié de "facteur 1" dès lors qu'il est conçu et qu'il fonctionne de telle manière que sensiblement la même distance de détection Sn s'applique à tous les métaux, ou au moins aux principaux d'entre eux (c'est-à-dire au moins : acier, fer, aluminium, cuivre, laiton, zinc et leurs possibles alliages).

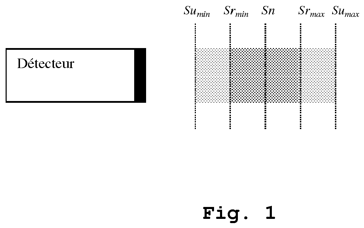

La figure 1 illustre schématiquement les principaux paramètres intervenant dans la définition des performances/caractéristiques de ce type de capteurs. Sur cette figure sont indiquées :
- la portée nominale "Sn" : Portée conventionnelle servant à désigner le détecteur ;
- la portée réelle "Sr" : Portée mesurée sous la tension d'alimentation nominale et à température ambiante (+/- 10 % de Sn) ;
- la portée utile "Su" : Portée mesurée dans les limites admissibles de température et de tension d'alimentation (+/- 10 % de Sr).

De nombreuses réalisations de détecteurs "facteur 1" existent déjà, tels que par exemple les systèmes basés sur de l'émission/réception (montage type transformateur) avec 3 ou 4 bobines (voir US 7,106,052 et EP 2 493 076 A1) ou des systèmes basés sur de la mesure de fréquence (voir EP 2 017 652 A1).

Le document US 2003/184301 propose un capteur de température au niveau de la bobine de mesure. Le document US 2014/376586 met en œuvre un moyen de chauffage permettant d'agir sur la température, et non de modifier le signal de mesure.

Toutefois, ces systèmes qui mettent en œuvre plusieurs bobines, sont complexes, couteux et encombrants. Par ailleurs, un système basé sur la fréquence peut faire appel à des composants onéreux tout en ayant des performances souvent limitées (faible fréquence de commutation, faible distance de détection).

Pour pallier ces inconvénients, il a été proposé un dispositif détecteur de proximité ou de présence, de type inductif et fonctionnant en mode "facteur 1", c'est-à-dire présentant une très faible variation de la distance de détection Sn en fonction des principaux types de métaux et comprenant essentiellement, d'une part, un circuit résonnant LC alimenté par un générateur d'impulsions d'excitation définissant des phases successives et répétitives de détection, d'autre part, une chaîne opérationnelle de moyens d'acquisition et de traitement du signal de réponse, sous forme d'oscillations libres, délivré par ledit circuit de détection LC durant chaque phase de détection, comportant notamment un moyen d'échantillonnage et un circuit de conversion analogique numérique, et, enfin, un ensemble fonctionnel de moyens d'évaluation d'au moins une valeur calée temporellement du signal traité et de fourniture d'une information ou d'un signal logique de détection ou de non détection.

Un tel dispositif détecteur est par exemple connu, en partie au moins, du document EP 1 530 064.

Dans le cas d'un tel montage d'oscillateur libre de type LC résonnant, on observe :
- une variation de l'amplitude des oscillations lorsque la bobine est située à proximité d'un matériau ferromagnétique ;
- une variation de fréquence d'oscillation lorsque la bobine est située à proximité d'un matériau non ferromagnétique.

Pour faire une détection "facteur 1", il suffit de s'intéresser en fait à deux types de matériaux :
- l'acier, représentant les matériaux ferromagnétiques, provoquant une variation de Rs et donc une variation d'amplitude dans le cas d'un oscillateur libre LC ;
- l'aluminium, représentant les matériaux non ferromagnétiques, provoquant une variation de Ls et donc une variation de fréquence dans le cas d'un oscillateur libre LC.

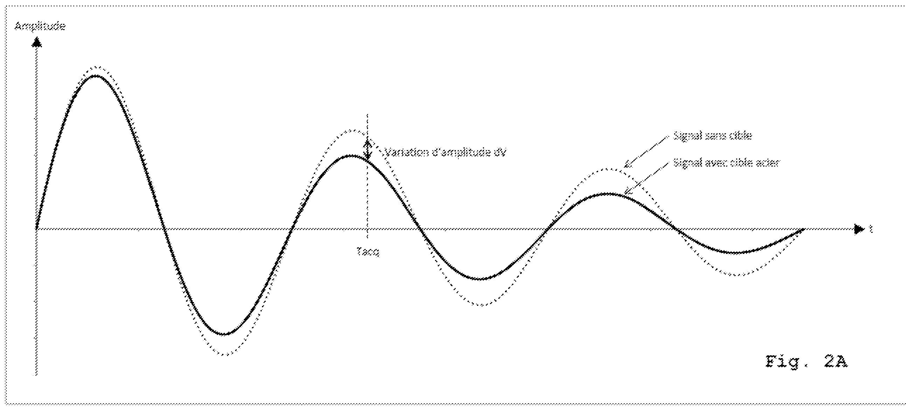

Dans le cas de l'acier, l'approche d'une cible provoque une atténuation des pseudo-oscillations, mais peu de variation en fréquence du signal (figure 2A).

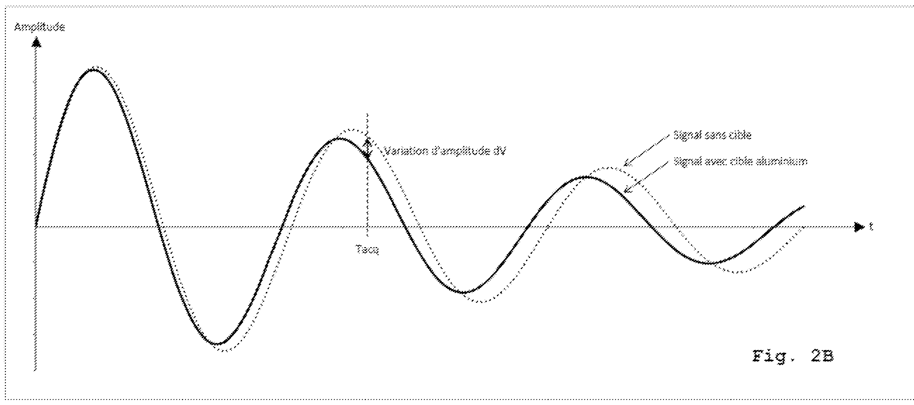

Dans le cas de l'aluminium, l'approche d'une cible provoque une augmentation de la fréquence des pseudo-oscillations, alors que l'amplitude du signal ne varie quasiment pas (figure 2B).

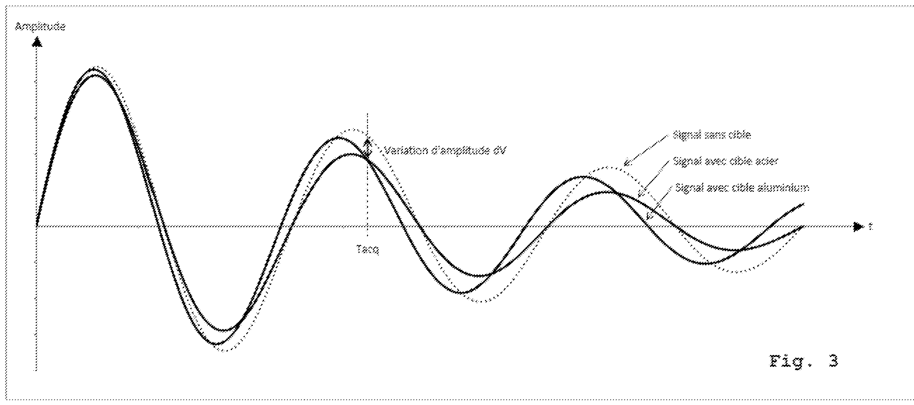

Le document EP 1 530 064 indique qu'il existe un instant d'échantillonnage "Trif" auquel les conditions de fonctionnement "facteur 1" sont vérifiées, c'est-à-dire où la diminution de l'amplitude du signal provoquée par l'approche d'une cible en acier est égale à la diminution de l'amplitude induite par le déphasage de la sinusoïde provoquée par l'approche d'une cible en aluminium (voir figure 3).

Dans ce document EP, l'instant "Trif" est déterminé par calcul, mais sans que la manière de déterminer les valeurs permettant de réaliser ce calcul ne soit indiquée. De plus, ni le procédé de fabrication, ni le procédé de réglage du détecteur ne sont évoqués dans ce document.

Par ailleurs, la construction de circuit divulguée par le document EP 1 530 064 exploite le signal de détection sous forme brute, en particulier non filtrée, et présente une faible dynamique du signal de détection et simultanément une forte dérive en température de ce dernier.

Le but de la présente invention est d'améliorer un dispositif détecteur fonctionnant en mode "facteur 1" du type divulgué par le document EP 1 530 064 précité, en surmontant au moins certaines des limitations de ce dernier et de fournir un dispositif présentant une portée de détection augmentée et assurant une détection fiable et reproductible.

A cet effet, l'invention a pour objet un dispositif détecteur de proximité ou de présence, de type inductif et de "facteur 1" tel qu'évoqué précédemment, caractérisé en ce que les moyens d'acquisition et de traitement comprennent, d'une part, des moyens analogiques de filtrage et/ou d'amplification du signal de réponse échantillonné, après son acquisition et avant sa conversion numérique, et, d'autre part, un moyen de compensation de la dérive en température du signal de réponse par correction du signal échantillonné après sa conversion numérique, associé à ou comportant un capteur de température fournissant une information sur la température d'au moins une partie du dispositif détecteur, comprenant le circuit résonnant LC et des moyens d'acquisition et de traitement de la chaîne opérationnelle situés en amont du circuit de conversion A/N.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 4 est un schéma synoptique des principaux éléments fonctionnels constitutifs du dispositif détecteur selon l'invention ;
les figures 5A à 5F sont des schémas électriques équivalents simplifiés de différentes variantes de réalisation de la chaîne opérationnelle de production et d'acquisition du signal de détection faisant partie du dispositif selon l'invention ;
la figure 6 est une représentation graphique (avec recalage temporel) des courbes [amplitude/temps] représentatives des signaux de détection (sinusoïdes pseudo-amorties) relevés aux bornes du circuit résonnant LC du dispositif détecteur selon l'invention, ce en réponse à une excitation impulsionnelle et respective en l'absence de cible, en présence d'une cible en acier (fer) à la distance Sn et en présence d'une cible en aluminium à la distance Sn ;
la figure 7 est une représentation à une échelle différente du détail A de la figure 6, montrant également les instants d'échantillonnage des signaux (seules les courbes des signaux "fer" et "aluminium" sont représentées) ;
les figures 8A à 8C illustrent différentes cas de positionnement de l'instant d'échantillonnage "facteur 1" (Tacq) par rapport aux instants d'échantillonnage prospectifs effectivement mis en œuvre durant la phase de test de réglage et de calibration du dispositif détecteur selon l'invention, et,
la figure 9 est un ordinogramme de la procédure d'apprentissage ou de calibration mise en œuvre dans le cadre de l'invention.

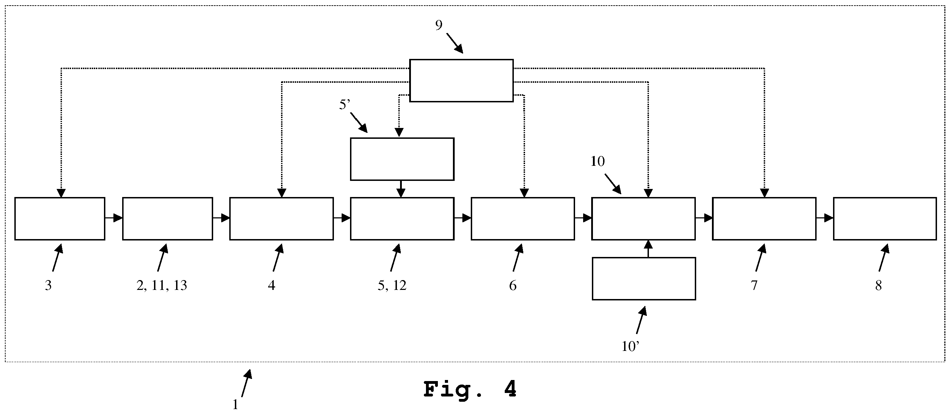

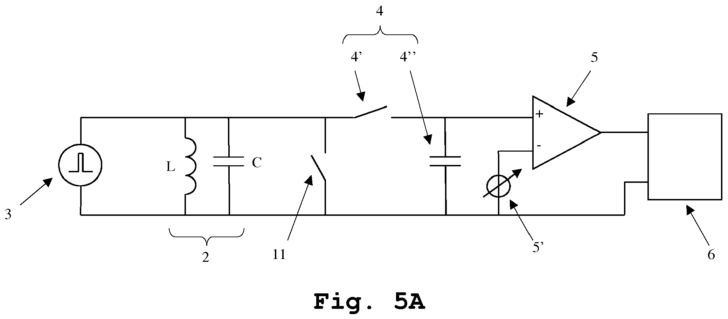

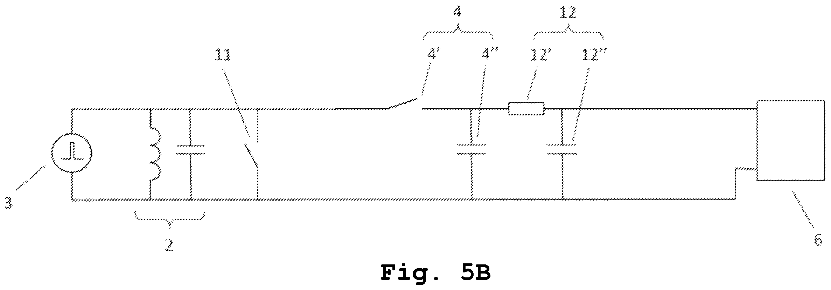

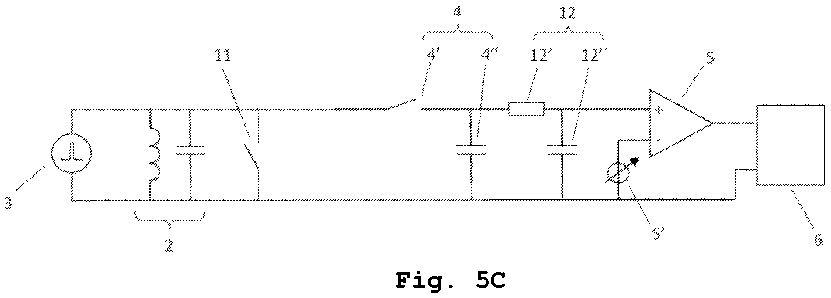

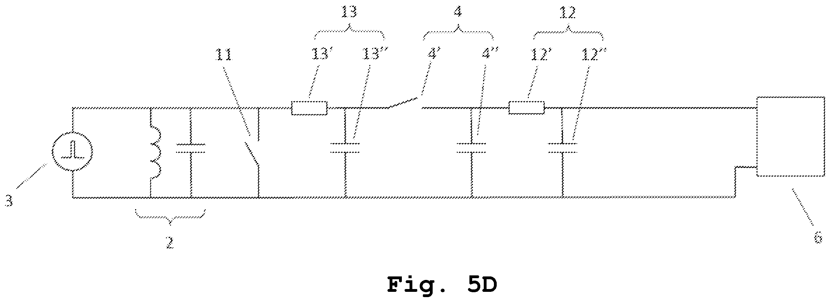

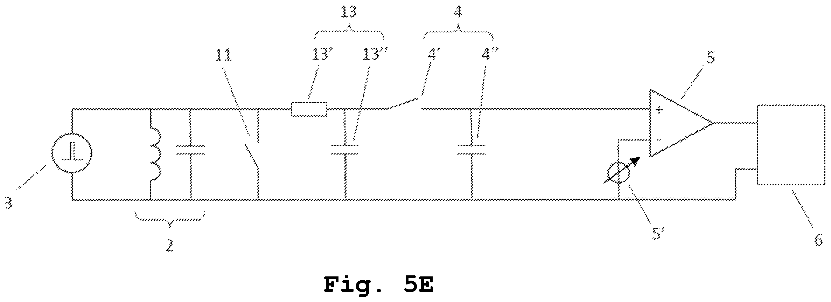

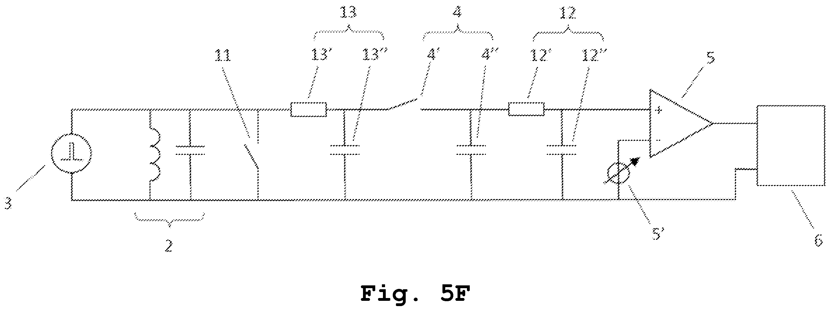

La figure 4 et partiellement les figures 5 illustrent synoptiquement et fonctionnellement, un dispositif détecteur 1 de proximité ou de présence, de type inductif et fonctionnant en mode "facteur 1".

Ce dispositif 1 comprend essentiellement, d'une part, un circuit 2 résonnant LC alimenté par un générateur 3 d'impulsions d'excitation définissant des phases successives et répétitives de détection, d'autre part, une chaîne opérationnelle de moyens 4, 5, 6, 12 d'acquisition et de traitement du signal de réponse (oscillations libres), délivré par ledit circuit 2 de détection LC durant chaque phase de détection, comportant notamment un moyen d'échantillonnage 4 et un circuit 6 de conversion analogique numérique, et, enfin, un ensemble fonctionnel de moyens 7, 8 d'évaluation, notamment par comparaison, d'au moins une valeur calée temporellement du signal traité et de fourniture d'une information ou d'un signal logique de détection ou de non détection.

Ce dispositif 1 comprend également une unité 9 de gestion et de commande, du type microcontrôleur, pour contrôler le fonctionnement dudit dispositif 1.

Conformément à l'invention, il est prévu que les moyens d'acquisition et de traitement précités comprennent, d'une part, des moyens 5 ; 12,13 analogiques de filtrage et/ou d'amplification du signal de réponse échantillonné, après son acquisition et avant sa conversion numérique, et, d'autre part, un moyen 10 de compensation de la dérive en température du signal de réponse par correction du signal échantillonné après sa conversion numérique, associé à ou comportant un capteur de température 10' fournissant une information sur la température d'au moins une partie du dispositif détecteur 1, comprenant le circuit 2 résonnant LC et des moyens 4, 5, 11, 12, 13 d'acquisition et de traitement de la chaîne opérationnelle situés en amont du circuit 6 de conversion A/N.

Grâce à ces dispositions particulières qui contribuent cumulativement à l'amélioration des performances en termes de qualité et de précision, et donc de la portée maximale, du dispositif détecteur 1, la dynamique du signal exploitable et son indépendance vis-à-vis des variations de température sont nettement améliorées par rapport à l'état de la technique.

Avantageusement, l'évaluation de la valeur échantillonnée à l'instant critique déterminé est effectuée par comparaison à une valeur seuil déterminée lors de la phase de calibration en production.

Préférentiellement, et comme le montrent les figures 5A, 5C, 5E et 5F, la chaîne opérationnelle comporte, à la suite du moyen d'échantillonnage 4, par exemple sous la forme d'un échantillonneur-bloqueur, un moyen d'amplification sous la forme d'un amplificateur différentiel, associé à un moyen 5' de soustraction de la composante continue du signal présenté à l'entrée de l'amplificateur différentiel 5.

En tant que dispositions constructives pratiques pour augmenter la dynamique du signal, il peut être prévu en outre :
- d'utiliser un échantillonneur bloqueur 4 externe au microcontrôleur 9, permettant de diminuer le temps d'échantillonnage, de mieux cibler le point à échantillonner et de réaliser un traitement analogique (amplification, filtrage) avant la conversion analogique-numérique ;
- d'augmenter la résolution du convertisseur A/N 6 (par exemple à 12 bits), ce circuit réalisant une conversion analogique-numérique du signal issu de l'amplificateur 5 et non une conversion directe du signal de sortie du circuit LC 2.

Afin d'éviter les signaux parasites ou interférents de fréquence élevée, il peut être prévu, comme illustré sur les figures 5B à 5D et 5F, que la chaîne opérationnelle comporte, à la suite du moyen d'échantillonnage 4 et en amont du circuit de conversion 6, ainsi que, le cas échéant, avant l'éventuel moyen d'amplification 5, un circuit de filtrage analogique 12, préférentiellement sous la forme d'un filtre RC passe-bas comprenant une résistance 12' en série et une capacité 12" en parallèle.

Pour faciliter et augmenter la fréquence et la répétabilité des cycles ou phases de détection, il peut être prévu, comme le montre symboliquement la figure 5, en aval du circuit de détection 2 LC et en amont du moyen d'échantillonnage 4, un moyen de commutation 11 pour décharger sélectivement ledit circuit LC 2.

L'échantillonneur bloqueur 4 peut, par exemple, comprendre un interrupteur 4' associé à une capacité 4" de mémorisation (voir figure 5).

De manière alternative ou additionnelle au premier circuit de filtrage 12 précité, éventuellement en association avec la présence d'un moyen d'amplification 5, la chaîne opérationnelle peut aussi comporter, en aval du circuit de détection LC 2 et en amont du moyen d'échantillonnage 4, un circuit de filtrage analogique 13, préférentiellement sous la forme d'un filtre RC passe-bas comprenant une résistance 13' en série et une capacité 13" en parallèle (figures 5D à 5F).

Les figures 5A à 5F illustrent les différentes variantes constructives possibles pour la chaîne opérationnelle du dispositif 1 selon l'invention ce en fonction des combinaisons et des présences ou non des différents moyens de filtrage et d'amplification 5, 12 et 13.

Dans le cadre d'une réalisation pratique de l'invention, les considérations suivantes peuvent être avantageusement prises en compte.

Le filtre 12, situé le cas échéant après l'échantillonneur 4, permet de stabiliser le signal avant la conversion analogique-numérique (suppression des perturbations induites pas l'échantillonneur, suppression de la diaphonie induite par le circuit oscillant LC, suppression des perturbations radiofréquences, ...). Sa fréquence de coupure est faible (par exemple de l'ordre de 16 kHz, mais elle peut varier en fonction des caractéristiques du dispositif détecteur 1, en particulier de sa fréquence de commutation). Dans le cas du montage de la figure 5D, la capacité 12" doit être suffisamment élevée (par exemple 10 nF minimum) afin de limiter l'atténuation induite par le transfert de charge de cette capacité 12" vers la capacité interne du convertisseur analogique-numérique 6 lors de la conversion.

Le filtre 13, situé le cas échéant avant l'échantillonneur 4, permet principalement de supprimer les perturbations radiofréquences captées par l'inductance du circuit LC (effet antenne). La fréquence de coupure de ce filtre 13 doit être plus élevée que la fréquence d'oscillation du circuit LC 2 afin de ne pas altérer le signal utile. La fréquence de coupure s'étend typiquement de quelques centaines de kHz à plusieurs dizaines ou centaines de MHz en fonction du type de perturbation radiofréquence présente. La capacité 13" doit être de faible valeur (quelques dizaines ou centaines de pF) et la résistance 13' peut être remplacée par une inductance de faible valeur ou une ferrite.

Ainsi, le filtrage de type "passe-bas" réalisé par le filtre 12 ou le filtre 13, ou encore par la mise en œuvre concomitante de ces deux filtres 12 et 13, permet, d'une part, de stabiliser le signal (avant et/ou après échantillonnage) et, d'autre part, d'immuniser le dispositif détecteur 1, et plus particulièrement la partie de sa chaîne opérationnelle située avant le convertisseur 6, contre les perturbations électromagnétiques haute fréquence, présentes dans les environnements industriels (comme par exemple une chaîne d'assemblage, notamment par soudage).

Bien entendu, les résistances 12' et 13' peuvent être remplacées par des inductances.

Concernant le gain du moyen d'amplification 5, il devrait être suffisamment élevé afin d'améliorer sensiblement la dynamique du signal utile. Il ne devrait pas être trop élevé non plus afin d'éviter de faire saturer l'amplificateur 5, en particulier en cas de dérive du signal et de sa composante continue lors des variations de température. Un gain compris entre 5 et 10, préférentiellement fixé à environ 6, a donné des résultats satisfaisants lors d'essais effectués par les inventeurs.

En accord avec une caractéristique avantageuse de l'invention, le moyen 10 de compensation de la dérive en température consiste en une tâche logicielle exécutée par le microcontrôleur 9, à chaque phase de détection, avec exploitation, d'une part, de la valeur mesurée par le capteur de température 10' et, d'autre part, d'informations stockées résultant d'évaluations expérimentales antérieures et relatives à l'influence de la température sur le signal de détection, ces informations stockées consistant en une fonction de compensation estimée ou en un tableau de correspondance par exemple.

Ainsi, en vue de réaliser une compensation suffisamment précise et répétable pour respecter les contraintes normatives (cf. EN60947-5-2 autorisant une dérive en température de +/- 10 % de la portée réelle), la solution retenue par l'invention pour compenser la dérive en température est basée sur une correction numérique du signal à partir d'une température relevée via un capteur de température 10'.

Pour mettre au point cette compensation en température, il est nécessaire de relever préalablement la dérive du signal en fonction de la température. Ces mesures de dérive s'effectuent avec les valeurs de sortie du convertisseur A/N 6 afin de compenser à la fois la dérive du capteur inductif (circuit LC 2) ainsi que de toute la chaine d'acquisition consécutive.

Après avoir réalisé préalablement (dans une phase de mise au point) des relevés numériques de la dérive du signal sur une pluralité de dispositifs détecteurs 1 identiques, il est possible de déterminer une dérive moyenne et répétable pour au moins une série de tels dispositifs 1. Il est possible de compenser la dérive à l'aide d'une fonction directement codée dans le microcontrôleur 9. La compensation peut aussi s'effectuer via un tableau de correspondance (dit "look up table").

Selon une autre caractéristique de l'invention, permettant d'éviter tout calcul complexe, ainsi que le recours à des ressources à cet effet, il est avantageusement prévu que la valeur de calage temporelle (valeur de temporisation après la fin de l'impulsion d'excitation), qui est exploitée par le microcontrôleur 9 pour commander l'échantillonneur bloqueur 4 et qui correspond au point "facteur 1", consiste en un couple [valeur d'amplitude ; temporisation après fin de l'impulsion d'excitation] déterminé expérimentalement par échantillonnage des signaux de réponse fournis par des cibles respectivement en fer et en aluminium placées à la distance de détection Sn souhaitée, ces signaux de réponse étant relevés avec le dispositif détecteur 1 prêt à être utilisé.

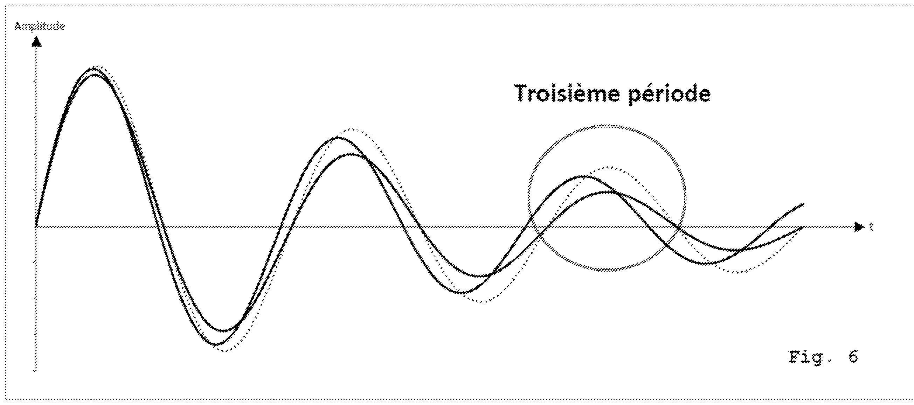

Dans la pratique, et comme le montre la figure 6, le point "facteur 1" choisi correspond préférentiellement à l'intersection des deux courbes des signaux de réponse des cibles en fer et en aluminium, sous forme de pseudo-oscillations sinusoïdales amorties, dans la phase descendante de l'alternance positive de leur troisième période. Néanmoins, tout autre point d'intersection entre les deux courbes peut être utilisé, y compris ceux durant les alternances négatives des signaux de réponse.

Ainsi, en accord avec une caractéristique de l'invention, il est prévu, en phase de réglage, de déterminer :
- le point d'échantillonnage optimal permettant une détection "facteur 1" ;
- le point de commutation du dispositif 1 lié à la portée requise Sn.

Dans la pratique, la solution retenue est basée sur la recherche du point "facteur 1" par échantillonnages successifs. Ce procédé permet de rechercher le point optimal une fois le dispositif 1 entièrement assemblé et résiné, tout en éliminant l'emploi d'un dispositif externe (calculateur, ...) et coûteux. Cette technique permet également d'approcher au mieux la portée nominale Sn, propriété particulièrement intéressante dans le cas de portées augmentées et/ou de plages de température étendues.

Pour chacun des deux matériaux de référence (Fer et Aluminium) placé à la distance de détection Sn souhaitée, le microcontrôleur 9 réalise N mesures autour du point "facteur 1" avec un instant d'échantillonnage "Tacq" variant de T0 à T0+N.dt (Tacq = T0 + N x dt avec dt correspondant à la résolution temporelle et N variant de 0 à 9 dans ce cas). Les amplitudes correspondant aux différents échantillons sont stockées dans des tableaux ("ValeurFer" et "ValeurAlu").

Bien que le point "facteur 1" (croisement des courbes Fer/Alu) existe sur chacune des périodes du signal oscillatoire amorti, l'échantillonnage au début de la phase descendante de la troisième période (voir figure 6) apparaît comme un bon compromis en terme de stabilité.

Le nombre N de points d'échantillonnage doit être choisi assez grand (au moins 10) afin de pouvoir trouver le "point facteur 1" dans tous les cas : il est en effet nécessaire de prendre en compte les tolérances initiales des composants qui introduisent des variations d'amplitude, de fréquence ou de base de temps d'une pièce à l'autre.

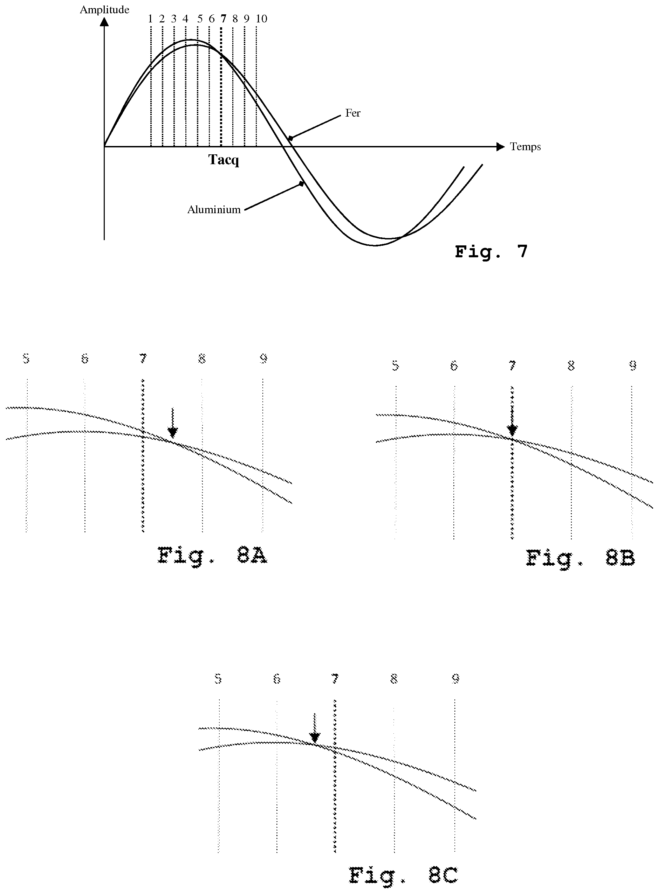

Les résultats des échantillonnages des deux courbes de la figure 7 sont présentés dans le tableau suivant en deux parties :

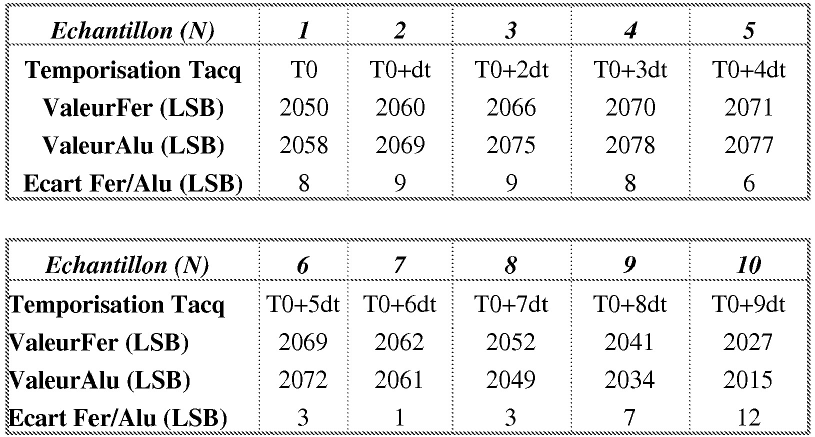

Les valeurs "ValeurFer" et "ValeurAlu" sont ensuite comparées entre elles, ce qui permet de déterminer la valeur absolue de l'écart entre la valeur ValeurFer[N] et ValeurAlu[N]. L'écart le plus faible correspond au point d'échantillonnage le plus proche du point "facteur 1" qui est le point de croisement des deux courbes de réponse Fer et Aluminium.

L'indice M correspondant à l'écart Fer/Aluminium le plus faible permet de déterminer :
- l'instant d'échantillonnage Tacq = T0 + M x dt optimal pour une détection "facteur 1" ;
- le seuil de détection choisi correspondant à la moyenne entre ValeurFer[M] et ValeurAlu[M].

L'instant d'échantillonnage Tacq correspond théoriquement au croisement entre les courbes de réponse Fer et Aluminium, mais en pratique, un écart peut être observé entre le point d'échantillonnage et le croisement réel des deux courbes - voir figures 8A à 8C). En phase de développement, il est nécessaire de vérifier que malgré cet écart, le dispositif détecteur 1 peut toujours être considéré comme "facteur 1", c'est-à-dire que la variation de la portée réelle Sr en fonction des matériaux dû à cet écart reste toujours dans les +/- 10 % de Sn autorisés par la norme EN60947-5-2.

En phase de production, le réglage du point d'échantillonnage Tacq et le réglage de la distance de détection Sn s'effectue en deux étapes successives (les deux étapes peuvent être interverties) :
1. Une cible en acier est placée devant le dispositif détecteur 1 à la distance Sn et une commande lance une séquence d'apprentissage permettant de compléter le tableau "ValeurFer". Le détecteur signale la fin de cette procédure à l'aide de sa sortie.
2. Une cible en aluminium est placée devant le dispositif détecteur 1 à la distance Sn et une commande lance une séquence d'apprentissage permettant de compléter le tableau "ValeurAlu".

Ensuite, à l'aide des deux tableaux, le microcontrôleur 9 est en mesure de déterminer le point d'échantillonnage optimal et le seuil de détection. Ces deux paramètres sont ensuite sauvegardés en mémoire, et rappelés à chaque démarrage du détecteur. Le dispositif détecteur 1 signale la fin de cette procédure à l'aide de sa sortie.

L'envoi de la commande d'apprentissage peut s'effectuer via une interface de paramétrage communicant via les lignes d'alimentation et la sortie du dispositif détecteur, comme divulgué par exemple dans le document EP 2 748 936 au nom de la demanderesse.

Un autre point important pour se rapprocher au maximum du point "facteur 1" est de prévoir une résolution temporelle élevée pour l'échantillonnage et donc un cycle d'horloge élevé et stable pour le microcontrôleur 9, préférentiellement de l'ordre de 32 MHz au moins et avec une faible dérive en température. De ce fait, des bases de temps du type résonateurs quartz ou oscillateurs MEMS sont à privilégier.

L'invention a également pour objet un procédé de calibration d'un dispositif détecteur 1 tel qu'évoqué ci-dessus, caractérisé en ce qu'il consiste à placer successivement une cible en fer et une cible en aluminium à la distance de détection Sn souhaitée, acquérir une pluralité d'échantillons, préférentiellement au moins dix, du signal de réponse sinusoïdal fourni par le circuit de détection LC 2 du dispositif détecteur 1 après excitation impulsionnelle dudit circuit, avantageusement durant la phase descendante de la première alternance de la troisième période de ces deux signaux, et à déterminer par comparaison, et éventuelle interpolation, les coordonnées (amplitude, temps) du point d'intersection des courbes représentatives des deux signaux de réponse correspondant au point "facteur 1".

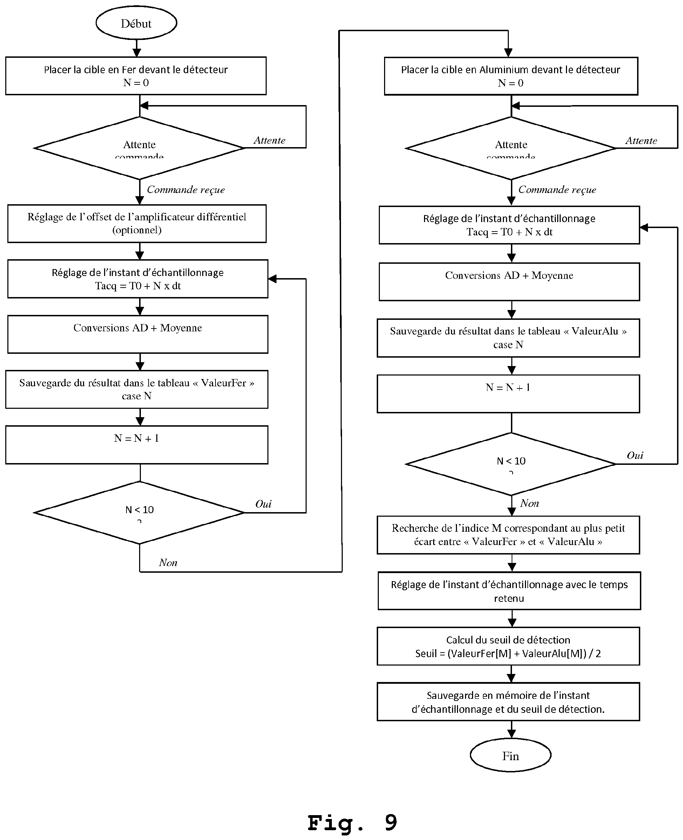

Un possible mode de réalisation pratique des différentes étapes du procédé précité est illustré sur la figure 9.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention qui est définie par les revendications.

## Revendications

1. Dispositif détecteur (1) de proximité ou de présence, de type inductif et fonctionnant en mode "facteur 1", c'est-à-dire présentant une très faible variation de sa distance de détection Sn en fonction des différents principaux types de métaux,
ledit dispositif détecteur (1) comprenant essentiellement, d'une part, un circuit (2) résonnant LC alimenté par un générateur (3) d'impulsions d'excitation définissant des phases successives et répétitives de détection, d'autre part, une chaîne opérationnelle de moyens (4, 5, 6, 12) d'acquisition et de traitement du signal de réponse, sous forme d'oscillations libres, délivré par ledit circuit (2) de détection LC durant chaque phase de détection, comportant notamment un moyen d'échantillonnage (4) et un circuit (6) de conversion analogique numérique, et, enfin, un ensemble fonctionnel de moyens (7, 8) d'évaluation, notamment par comparaison, d'au moins une valeur calée temporellement du signal traité et de fourniture d'une information ou d'un signal logique de détection ou de non détection, ledit dispositif (1) comprenant également une unité (9) de gestion et de commande, du type microcontrôleur, pour contrôler le fonctionnement dudit dispositif (1),
dispositif détecteur (1) **caractérisé en ce que** les moyens d'acquisition et de traitement comprennent, d'une part, des moyens (5 ; 12, 13) analogiques de filtrage et/ou d'amplification du signal de réponse échantillonné, après son acquisition et avant sa conversion numérique, et, d'autre part, un moyen (10) de compensation de la dérive en température du signal de réponse par correction du signal échantillonné après sa conversion numérique, associé à ou comportant un capteur de température (10') fournissant une information sur la température d'au moins une partie du dispositif détecteur (1), comprenant le circuit (2) résonnant LC et des moyens (4, 5, 11, 12 ,13) d'acquisition et de traitement de la chaîne opérationnelle situés en amont du circuit (6) de conversion A/N.

2. Dispositif détecteur selon la revendication 1, **caractérisé en ce que** la chaîne opérationnelle comporte, à la suite du moyen d'échantillonnage (4) sous la forme d'un échantillonneur-bloqueur, un moyen d'amplification (5) sous la forme d'un amplificateur différentiel, associé à un moyen (5') de soustraction de la composante continue du signal présenté à l'entrée de l'amplificateur différentiel (5).

3. Dispositif détecteur selon la revendication 1 ou 2, **caractérisé en ce que** la chaîne opérationnelle comporte, à la suite du moyen d'échantillonnage (4) et en amont du circuit de conversion (6), ainsi que, le cas échéant, avant l'éventuel moyen d'amplification (5), un circuit de filtrage analogique (12), préférentiellement sous la forme d'un filtre RC passe-bas comprenant une résistance (12') en série et une capacité (12") en parallèle.

4. Dispositif détecteur selon l'une quelconque des revendications 1 à 3, **caractérisé en ce qu'**il comprend également, en aval du circuit de détection (2) LC et en amont du moyen d'échantillonnage (4), un moyen de commutation (11) pour décharger sélectivement ledit circuit LC (2).

5. Dispositif détecteur selon l'une quelconque des revendications 1 à 4, **caractérisé en ce que** la chaîne opérationnelle comporte, en aval du circuit de détection LC (2) et en amont du moyen d'échantillonnage (4), un circuit de filtrage analogique (13), préférentiellement sous la forme d'un filtre RC passe-bas comprenant une résistance (13') en série et une capacité (13") en parallèle.

6. Dispositif détecteur selon l'une quelconque des revendications 1 à 5, **caractérisé en ce que** le moyen (10) de compensation de la dérive en température consiste en une tâche logicielle exécutée par le microcontrôleur (9), à chaque phase de détection, avec exploitation, d'une part, de la valeur mesurée par le capteur de température (10') et, d'autre part, d'informations stockées résultant d'évaluations expérimentales antérieures et relatives à l'influence de la température sur le signal de détection, ces informations stockées consistant en une fonction de compensation estimée ou en un tableau de correspondance par exemple.

7. Dispositif détecteur selon l'une quelconque des revendications 1 à 6, **caractérisé en ce que** la valeur de calage temporelle, qui est exploitée par le microcontrôleur (9) pour commander l'échantillonneur bloqueur (4) et qui correspond au point "facteur 1", consiste en un couple [valeur d'amplitude ; temporisation après fin de l'impulsion d'excitation] déterminé expérimentalement par échantillonnage des signaux de réponse fournis par des cibles respectivement en fer et en aluminium placés à la distance de détection (Sn) souhaitée, ces signaux de réponse étant relevés avec le dispositif détecteur (1) prêt à être utilisé.

8. Dispositif détecteur selon la revendication 7, **caractérisé en ce que** le point "facteur 1" choisi correspond à l'intersection des deux courbes des signaux de réponse des cibles en fer et en aluminium, sous forme de pseudo-oscillations sinusoïdales amorties, dans la phase descendante de l'alternance positive de leur troisième période.

9. Procédé de calibration d'un dispositif détecteur selon l'une quelconque des revendications 1 à 8, **caractérisé en ce qu'**il consiste à placer successivement une cible en fer et une cible en aluminium à la distance de détection (Sn) souhaitée, acquérir une pluralité d'échantillons, préférentiellement au moins dix, du signal de réponse sinusoïdal fourni par le circuit de détection LC (2) du dispositif détecteur (1) après excitation impulsionnelle dudit circuit, avantageusement durant la phase descendante de la première alternance de la troisième période de ces deux signaux, et à déterminer par comparaison, et éventuelle interpolation, les coordonnées (amplitude, temps) du point d'intersection des courbes représentatives des deux signaux de réponse correspondant au point "facteur 1".

## Patentansprüche

1. Näherungs- oder Anwesenheitsdetektorvorrichtung (1) vom induktiven Typ, der in der Betriebsart "Faktor 1" arbeitet, d.h. nur eine sehr geringe Variation seines Detektionsabstandes Sn in Abhängigkeit von den verschiedenen, wichtigsten Metallarten aufweist,
wobei die genannte Detektorvorrichtung (1) im Wesentlichen einerseits einen LC-Resonanzschaltkreis (2) umfasst, der durch einen Anregungsimpulsgenerator (3) gespeist wird, der aufeinanderfolgende und sich wiederholende Detektionsphasen definiert, andererseits eine Verarbeitungskette aus Mitteln (4, 5, 6, 12) zur Erfassung und Verarbeitung des Antwortsignals in Form freier Schwingungen, das vom genannten LC-Detektionskreis (2) während jeder Detektionsphase ausgegeben wird, die insbesondere ein Signalabtastmittel (4) und eine Analog-Digital-Wandlerschaltung (6) aufweist, und schließlich eine funktionelle Einheit aus Mitteln (7, 8) zur Auswertung insbesondere durch Vergleich mindestens eines auf einen Zeitpunkt bezogenen Wertes des verarbeiteten Signals und zur Ausgabe einer Information oder eines logischen Signals der Detektion oder Nicht-Detektion, wobei die genannte Vorrichtung (1) ebenfalls eine Kontroll- und Steuereinheit (9) vom Typ Mikrosteuergerät umfasst, um die Arbeit der genannten Vorrichtung (1) zu steuern, Detektorvorrichtung (1), **dadurch gekennzeichnet, dass** die Erfassungs- und Verarbeitungsmittel einerseits analoge Mittel (5; 12,13) zur Filterung und/oder Verstärkung des abgetasteten Antwortsignals nach seiner Erfassung und vor seiner Digitalwandlung umfassen, und andererseits ein Mittel (10) zur Kompensation der Temperaturdrift des Antwortsignals durch Korrektur des abgetasteten Signals nach seiner Digitalwandlung, in Verbindung mit einem Temperatursensor (10') oder einen solchen aufweisend, der eine Information über die Temperatur mindestens eines Teils der Detektorvorrichtung (1) ausgibt, der den LC-Resonanzkreis (2) und Mittel (4, 5, 11, 12, 13) zur Erfassung und Verarbeitung der Verarbeitungskette umfasst, die sich vor der Analog-Digital-Wandlerschaltung (6) befinden.

2. Detektorvorrichtung nach Patentanspruch 1, **dadurch gekennzeichnet, dass** die Verarbeitungskette auf das Abtastmittel (4), in Form eines Abtast-Halte-Gliedes, folgend ein Verstärkermittel (5), in Form eines Differentialverstärkers, in Verbindung mit einem Mittel (5') zur Subtraktion der Gleichspannungskomponente des Signals, das am Eingang des Differentialverstärkers (5) anliegt, aufweist.

3. Detektorvorrichtung nach Patentanspruch 1 oder 2, **dadurch gekennzeichnet, dass** die Verarbeitungskette nach dem Abtastmittel (4) und vor der Wandlerschaltung (6), sowie gegebenenfalls vor dem eventuellen Verstärkermittel (5), eine analoge Filterschaltung (12) aufweist, vorzugsweise in Form eines RC-Tiefpassfilters, einen Widerstand (12') in Reihe und einen Kondensator (12") parallel geschaltet umfassend.

4. Detektorvorrichtung nach irgendeinem der Patentansprüche 1 bis 3, **dadurch gekennzeichnet, dass** sie außerdem nach dem LC-Detektionskreis (2) und vor dem Abtastmittel (4) ein Schaltmittel (11) aufweist, um den genannten LC-Kreis (2) selektiv zu entladen.

5. Detektorvorrichtung nach irgendeinem der Patentansprüche 1 bis 4, **dadurch gekennzeichnet, dass** die Verarbeitungskette nach dem LC-Detektionskreis (2) und vor dem Abtastmittel (4) eine analoge Filterschaltung (13) aufweist, vorzugsweise in Form eines RC-Tiefpassfilters, einen Widerstand (13') in Reihe und einen Kondensator (13") parallel geschaltet umfassend.

6. Detektorvorrichtung nach irgendeinem der Patentansprüche 1 bis 5, **dadurch gekennzeichnet, dass** das Mittel (10) zur Kompensation der Temperaturdrift in einem Software-Task besteht, der vom Mikrosteuergerät (9) in jeder Detektionsphase ausgeführt wird, unter Verwendung einerseits des Wertes, der vom Temperatursensor (10') gemessen wurde, und andererseits von gespeicherten Informationen, die vorherigen experimentellen Auswertungen entstammen und sich auf den Einfluss der Temperatur auf das Detektionssignal beziehen, wobei diese gespeicherten Informationen beispielsweise in einer geschätzten Kompensationsfunktion oder einer Korrespondenzwerttabelle bestehen.

7. Detektorvorrichtung nach irgendeinem der Patentansprüche 1 bis 6, **dadurch gekennzeichnet, dass** der zeitbezogene Wert, der vom Mikrosteuergerät (9) verwendet wird, um das Abtast-Halte-Glied (4) zu steuern und der dem "Faktor 1"-Punkt entspricht, aus einem Paar [Amplitudenwert; Zeitverzögerung nach Anregungsimpulsende] besteht, das experimentell durch Abtastung der Antwortsignale bestimmt wurde, die von Zielen aus Eisen bzw. aus Aluminium bewirkt wurden, die im gewünschten Detektionsabstand angeordnet wurden, wobei diese Antwortsignale mit der gebrauchsbereiten Detektionsvorrichtung (1) ermittelt wurden.

8. Detektorvorrichtung nach Patentanspruch 7, **dadurch gekennzeichnet, dass** der gewählte "Faktor 1"-Punkt dem Schnittpunkt der beiden Antwortsignalkurven der Ziele aus Eisen und aus Aluminium in Form gedämpfter Pseudo-Sinusschwingungen in der abfallenden Phase der positiven Halbwelle ihrer dritten Periode entspricht.

9. Kalibrierverfahren einer Detektorvorrichtung nach irgendeinem der Patentansprüche 1 bis 8, **dadurch gekennzeichnet, dass** es darin besteht, nacheinander ein Ziel aus Eisen und ein Ziel aus Aluminium im gewünschten Detektionsabstand (Sn) anzuordnen, mehrere Abtastungen, vorzugsweise mindestens zehn, des vom LC-Detektionskreis (2) der Detektionsvorrichtung (1) nach Impulsanregung des genannten Schaltkreises abgegebenen Antwortsinussignals zu erfassen, vorteilhafterweise in der abfallenden Phase der positiven Halbwelle der dritten Periode dieser beiden Signale, und durch Vergleich und gegebenenfalls Interpolation die Koordinaten (Amplitude, Zeit) des Schnittpunktes der Kurven, die die beiden Antwortsignale darstellen, zu bestimmen, der dem "Faktor 1"-Punkt entspricht.

## Claims

1. Inductive proximity or presence sensor device (1), which operates in "factor 1" mode, i.e. with very little variation in its sensing distance Sn with respect to the various main types of metals,
said sensor device (1) essentially comprising, firstly, an LC resonant circuit (2) powered by a pulse generator (3) that generates excitation pulses defining successive and recurring sensing phases, secondly, an operational chain of means (4, 5, 6, 12) for acquiring and processing the response signal, in the form of free oscillations, delivered by said LC sensing circuit (2) during each sensing phase, said means including in particular a sampling means (4) and an analogue-to-digital conversion circuit (6), and, finally, a functional set of means (7, 8) for evaluating, in particular by comparison, at least one temporally adjusted value of the processed signal and for providing an item of information or a logic signal indicating that an object has or has not been sensed, said device (1) also comprising a microcontroller-type management and control unit (9) for controlling the operation of said device (1),
which sensor device (1) is **characterized in that** the acquisition and processing means comprise, firstly, analogue means (5; 12, 13) for filtering and/or amplifying the sampled response signal after the acquisition thereof and before the digital conversion thereof, and, secondly, a means (10) for compensating for the temperature drift of the response signal by correcting the sampled signal after the digital conversion thereof, said compensation means being associated with or including a temperature sensor (10'), which provides an item of information regarding the temperature of at least a part of the sensor device (1) comprising the LC resonant circuit (2) and acquisition and processing means (4, 5, 11, 12, 13) of the operational chain that are located upstream of the A/D conversion circuit (6).

2. Sensor device according to Claim 1, **characterized in that** the operational chain includes, downstream of the sampling means (4) in the form of a sample-and-hold device, an amplifying means (5) in the form of a differential amplifier, associated with a means (5') for removing the DC component from the signal provided at the input of the differential amplifier (5).

3. Sensor device according to Claim 1 or 2, **characterized in that** the operational chain includes, downstream of the sampling means (4) and upstream of the conversion circuit (6), and also, if applicable, upstream of the optional amplifying means (5), an analogue filtering circuit (12), preferably in the form of a low-pass RC filter comprising a resistor (12') in series and a capacitor (12") in parallel.

4. Sensor device according to any one of Claims 1 to 3, **characterized in that** it also comprises, downstream of the LC sensing circuit (2) and upstream of the sampling means (4), a switching means (11) for selectively discharging said LC circuit (2).

5. Sensor device according to any one of Claims 1 to 4, **characterized in that** the operational chain includes, downstream of the LC sensing circuit (2) and upstream of the sampling means (4), an analogue filtering circuit (13), preferably in the form of a low-pass RC filter comprising a resistor (13') in series and a capacitor (13") in parallel.

6. Sensor device according to any one of Claims 1 to 5, **characterized in that** the means (10) for compensating for the temperature drift consists of a software task executed by the microcontroller (9) during each sensing phase using, firstly, the value measured by the temperature sensor (10') and, secondly, stored items of information resulting from earlier experimental evaluations and relating to the influence of temperature on the sensing signal, these stored items of information consisting of an estimated compensation function or a lookup table, for example.

7. Sensor device according to any one of Claims 1 to 6, **characterized in that** the temporal adjustment value, which is used by the microcontroller (9) to control the sample-and-hold device (4) and corresponds to the "factor 1" point, consists of an [amplitude value; time lag after end of excitation pulse] pair determined experimentally by sampling the response signals provided by targets made of iron and aluminium, respectively, which are placed at the desired sensing distance (Sn), these response signals being recorded by means of the sensor device (1), which is ready for use.

8. Sensor device according to Claim 7, **characterized in that** the "factor 1" point chosen corresponds to the intersection of the two curves of the response signals of the iron and aluminium targets, in the form of damped sinusoidal pseudo-oscillations, in the descending phase of the positive half-cycle of the third period thereof.

9. Method for calibrating a sensor device according to any one of Claims 1 to 8, **characterized in that** it consists in successively placing an iron target and an aluminium target at the desired sensing distance (Sn), acquiring a plurality of samples, preferably at least ten, of the sinusoidal response signal provided by the LC sensing circuit (2) of the sensor device (1) after pulse excitation of said circuit, advantageously during the descending phase of the first half-cycle of the third period of these two signals, and in determining, by comparison and optional interpolation, the (amplitude, time) coordinates of the point of intersection of the curves representing the two response signals, which point of intersection corresponds to the "factor 1" point.
